# EUROPÄISCHE PATENTANMELDUNG

(11) **EP 1 976 353 A2**
(43) Veröffentlichungstag der Anmeldung: **01.10.2008**
(21) Anmeldenummer: 08102594.2
(22) Anmeldetag: 13.03.2008
(51) Int. Cl.: H05K 3/24

(54) **Verfahren zum Galvanisieren einer Leiterstruktur auf der Oberseite einer Mehrlagenleiterplatte und entsprechende Mehrlagenleiterplatte**

(30) Priorität: 26.03.2007 DE 102007014355
(71) Anmelder: ROBERT BOSCH GMBH, 70442 Stuttgart (DE)
(72) Erfinder: Binzer, Thomas, 70565, Stuttgart (DE); Miosga, Klaus-Dieter, 71522, Backnang (DE)

(57) **Zusammenfassung**

Die Erfindung betrifft ein Verfahren zum Galvanisieren mindestens einer ersten Leiterstruktur die sich auf der Oberseite einer Mehrlagenleiterplatte befindet. Es sind folgende Schritte vorgesehen:
- Einbringen eines Verbindungskanals, der von der ersten Leiterstruktur zu einer darunterliegenden, zweiten Leiterstruktur der Mehrlagenleiterplatte führt,
- Galvanisieren des Verbindungskanals zum elektrischen Verbinden der beiden Leiterstrukturen durch Erzeugung einer Querverbindung,
- Anlegen eines elektrischen Potentials an die zweite Leiterstruktur zwecks Beaufschlagung der ersten Leiterstruktur mit diesem Potential,
- Verwenden dieses Potentials für eine erfolgende Galvanisierung der ersten Leiterstruktur zum Erzeugen einer elektrisch leitenden Schicht auf der Außenseite der ersten Leiterstruktur und
- Trennen der Querverbindung durch Ausbohren des Verbindungskanals.

Weiterhin betrifft die Erfindung eine Mehrlagenleiterplatte mit einer entsprechend galvanisierten ersten Leiterstruktur auf der Oberseite der Mehrlagenleiterplatte.

## Beschreibung

Die Erfindung betrifft ein Verfahren zum Galvanisieren mindestens einer ersten Leiterstruktur, die sich auf der Oberseite einer Mehrlagenleiterplatte befindet.

### Stand der Technik

Ein derartiges Verfahren ist bekannt. Beim Aufbringen einer galvanischen Schicht auf einer ersten Leiterstruktur wird eine zusätzliche Leitung von der Leiterstruktur zu einer Leiterstruktur einer tiefer liegenden Lage mit festem Massepotential oder frei einstellbaren Potential erstellt, die nach dem Galvanisieren durch einen Ätz-, Bohr- oder Fräsprozess entfernt wird. Dieses wegätzen, wegbohren oder wegfräsen benötigt Zeit und verlängert den Herstellungsprozess.

### Offenbarung der Erfindung

Das erfindungsgemäße Verfahren weist folgende Schritte auf:
- Einbringen eines Verbindungskanals, der von der ersten Leiterstruktur zu einer darunterliegenden, zweiten Leiterstruktur der Mehrlagenleiterplatte führt,
- Galvanisieren des Verbindungskanals zum elektrischen Verbinden der beiden Leiterstrukturen durch Erzeugung einer Querverbindung,
- Anlegen eines elektrischen Potentials an die zweite Leiterstruktur zwecks Beaufschlagung der ersten Leiterstruktur mit diesem Potential,
- Verwenden dieses Potentials für eine erfolgende Galvanisierung der ersten Leiterstruktur zum Erzeugen einer elektrisch leitenden Schicht auf der Außenseite der ersten Leiterstruktur und
- Trennen der Querverbindung durch Ausbohren des Verbindungskanals.

Dieses Verfahren benötigt einen erheblich geringeren Aufwand als das herkömmliche wegätzen, abfräsen oder wegbohren von Verbindungsleitungen von der ersten Leiterstruktur zu der zweiten Leiterstruktur einer tieferliegenden Lage mit festem Massepotential oder frei einstellbaren Potential. Kern der Erfindung ist dabei die als sogenannte "Via" ausgebildete Querverbindung. Diese Querverbindung ist ein Standard-Element zur Kontaktierung von Leiterstrukturen unterschiedlicher Lagen einer Mehrlagenleiterplatte. Die erste Leiterstruktur ist insbesondere eine Patch-Struktur. Die zweite Leiterstruktur ist vorteilhafterweise eine sich in ihrer zugeordneten Lage über die Mehrlagenleiterplatte erstreckende Leiterstruktur. Eine solche Leiterstruktur ermöglich eine Beaufschlagung der ersten Leiterstruktur mit dem Potential der zweiten Leiterstruktur mittels Querverbindung an jeder Stelle der Mehrlagenleiterplatte. Verbindungskanäle mit größerem Durchmesser insbesondere durch Bohrung mittels Hartmetallwerkzeugen hergestellt. Der Verbindungskanal wird zur Metallisierung seiner Oberfläche vorteilhafterweise bekeimt. Anschließend erfolgt ein Abscheiden einer Metallschicht auf der Oberfläche. Der Verbindungskanal verläuft mit Vorteil nur durch die erste Leiterstruktur und eine zwischen den beiden Leiterstrukturen angeordnete, elektrisch isolierende Substratlage. Alternativ verläuft der Verbindungskanal insbesondere durch die erste Leiterstruktur, die zwischen den beiden Leiterstrukturen angeordnete, elektrisch isolierende Substratlage und die zweite Leiterstruktur. Zum Ausbohren der Querverbindung nach dem Galvanisieren der ersten Leiterstruktur wird ein Bohrer verwendet, dessen Durchmesser größer oder gleich dem der Querverbindung ist. Nach dem Ausbohren verbleibt zwischen der ersten und der zweiten Leiterstruktur ein galvanisierungsschichtfreier Verbindungskanal, der keine Leitfähigkeit aufweist.

Weiterhin ist mit Vorteil vorgesehen, dass der Verbindungskanal ein Mikrokanal ist. Dieser Mikrokanal mit metallisierter Oberfläche ist ein sogenanntes Microvia. Der Mikrokanal hat dabei insbesondere einen Durchmesser von 25 - 250 Mikrometern.

Insbesondere ist vorgesehen, dass das Einbringen des Verbindungskanals mittels Laserbohren oder Plasmaätzen erfolgt. Mittels Laserbohren oder Plasmaätzen lassen sich besonders feine Verbindungskanäle, insbesondere Mikrokanäle, in die Mehrlagenleiterplatte einbringen.

Nach einer Weiterbildung der Erfindung ist vorgesehen, dass die erste Leiterstruktur eine Hochfrequenz-Leiterstruktur ist. Bei einer Hochfrequenz-Leiterstruktur werden insbesondere als Microvias ausgebildete Querverbindungen genutzt.

In einer vorteilhaften Ausgestaltung der Erfindung ist vorgesehen, dass die erste Leiterstruktur eine Antenne ist. Ein vorzugsweise zentral in der Mitte einer als Antenne ausgebildeten Unterstruktur der ersten Leiterstruktur (oder der ersten Leiterstruktur selbst) angeordneter Verbindungskanal hat durch die Stromverteilung auf der ersten Leiterstruktur nur einen geringen Einfluss auf die Antenneneigenschaften.

Weiterhin ist mit Vorteil vorgesehen, dass die elektrisch leitende Schicht eine Goldschicht ist. Gold ist ein Edelmetall mit hoher Leitfähigkeit, dass eine gleichbleibend hohe Leitfähigkeit der gesamten ersten Leiterstruktur auch bei störenden Umwelteinflüssen gewährleistet. Eine als Antenne ausgebildete erste Leiterstruktur mit Goldschicht hat gute Antenneneigenschaften.

Die Erfindung betrifft weiterhin eine Mehrlagenleiterplatte mit einer galvanisierten ersten Leiterstruktur auf der Oberseite der Mehrlagenleiterplatte, insbesondere mit einer nach dem vorstehend genannten Verfahren galvanisierten ersten Leiterstruktur, wobei diese eine elektrisch leitende Schicht auf ihrer Außenseite aufweist. Es ist vorgesehen, dass ein galvanisierungsschichtfreier Kanal von der ersten Leiterstruktur zu einer darunterliegenden, zweiten Leiterstruktur der Mehrlagenleiterplatte führt. Dieser Kanal ist eine ausgebohrte Querverbindung zur Beaufschlagung der ersten Leiterstruktur mit einem Potential beim Galvanisieren. Bei dem Verfahren zum Galvanisieren der ersten Leiterplatte ergibt sich ein Prozessablauf, der folgende Schritte aufweist: Einbringen eines Verbindungskanals, der von der ersten Leiterstruktur zu der darunter liegenden, zweiten Leiterstruktur der Mehrlagenleiterplatte führt; Galvanisieren des Verbindungskanals zum elektrischen Verbinden der beiden Leiterstrukturen durch Erzeugung einer Querverbindung; Anlegen eines elektrischen Potentials an die zweite Leiterstruktur zwecks Beaufschlagung der ersten Leiterstruktur mit diesem Potential; Verwenden dieses Potentials für eine erfolgende Galvanisierung der ersten Leiterstruktur zum Erzeugen einer elektrisch leitenden Schicht auf der Außenseite der ersten Leiterstruktur; Trennen der Querverbindung durch Ausbohren des Verbindungskanals. Insbesondere ist vorgesehen, dass der galvanisierungsschichtfreie Kanal die nachträglich aufgebohrte Querverbindung ist. Dem Verbindungskanal ist somit anzusehen, dass er vor dem Aufbohren als Querverbindung zur Beaufschlagung der ersten Leiterstruktur mit einem Potential der zweiten Leiterstruktur für eine Galvanisierung der ersten Leiterstruktur zum Erzeugen einer elektrisch leitenden Schicht auf der Außenseite der ersten Leiterstruktur genutzt wurde. Weiterhin ist mit Vorteil vorgesehen, dass die beiden Leiterstrukturen voneinander elektrisch isoliert sind.

Nach einer Weiterbildung der Erfindung ist vorgesehen, dass die erste Leiterstruktur eine Hochfrequenz-Leiterstruktur, insbesondere eine Antenne, ist. Schließlich ist mit Vorteil vorgesehen, dass die elektrisch leitende Schicht eine Goldschicht ist.

### Kurze Beschreibung der Zeichnungen

Im Folgenden wird die Erfindung anhand eines in den Zeichnungen dargestellten Ausführungsbeispiels näher erläutert. Es zeigen
Figur 1 Eine Mehrlagenleiterplatte mit einer ersten Leiterstruktur auf der Oberseite der Mehrlagenleiterplatte, die mit einer darunter liegenden zweiten Leiterstruktur über eine Querverbindung leitend verbunden ist,
Figur 2 Die Mehrlagenleiterplatte der Figur 1 nach dem Trennen der Querverbindung durch Ausbohren des Verbindungskanals und
Figur 3 Die Mehrlagenleiterplatte der Figur 2 in einer dreidimensionalen Ansicht.

### Ausführungsform(en) der Erfindung

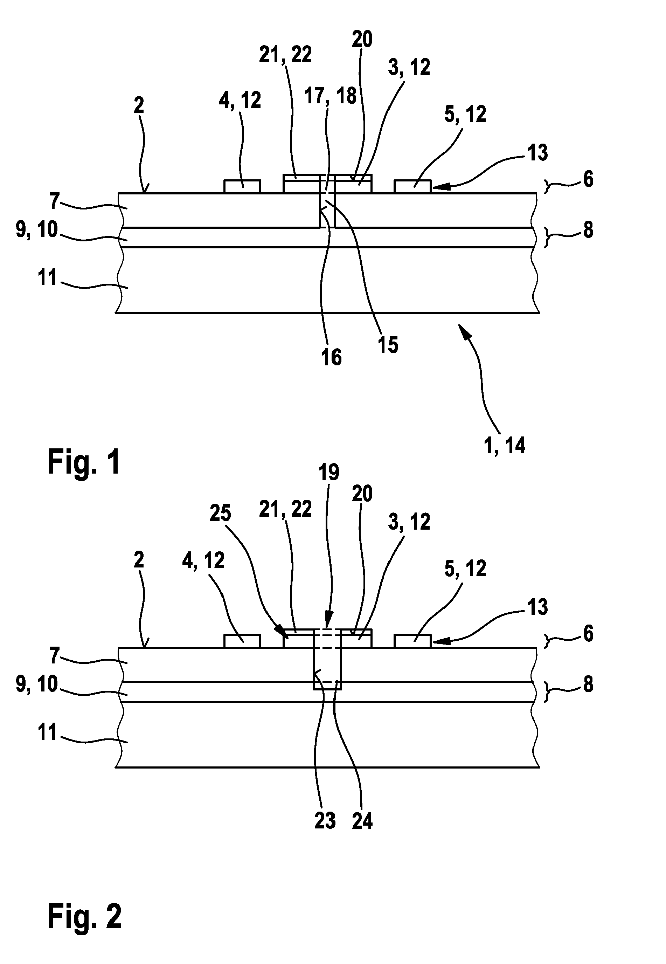

Die Figur 1 zeigt eine Mehrlagenleiterplatte 1 mit einer an seiner Oberseite 2 ausgebildeten ersten Leiterstruktur 3 und zwei weiteren Leiterstrukturen 4, 5 auf der Oberseite 2. Die Leiterstrukturen 3, 4, 5 an der Oberseite 2 liegen in einer ersten Lage 6 auf einer elektrisch isolierenden Substratschicht 7, die die erste Lage 6 von einer darunter liegenden zweiten Lage 8 trennt. In der zweiten Lage 8 ist eine sich über die gesamte Mehrlagenleiterplatine 1 erstreckende zweite Leiterstruktur 9 angeordnet, die als sogenannte Masselage 10 ausgebildet ist und eine Massefläche bildet. Die Masselage 10 liegt auf einer elektrisch isolierenden Trägerplatte 11. Die Leiterstrukturen 3, 4, 5 sind als Hochfrequenz-Leiterstrukturen 12 einer Hochfrequenzschaltung 13 ausgebildet. Die Mehrlagenleiterplatte 1 ist dabei eine Hochfrequenz-Mehrlagenleiterplatte 14. Die erste Leiterstruktur 3 ist mit der darunter liegenden zweiten Leiterstruktur 9 durch eine sich quer zu den Lagen 6, 8 durch die isolierende Substratschicht 7 erstreckende elektrische Querverbindung 15 verbunden. Die Querverbindung 15 besteht aus einer metallisierten Oberfläche 16 eines als Mikrokanal 17 ausgebildeten Verbindungskanals 18 zwischen der ersten Leiterstruktur 3 und der zweiten Leiterstruktur 9. Der Verbindungskanal 18 ist als Sacklochbohrung ausgebildet. Eine derartige Querverbindung 14 des Verbindungskanals 18 wird auch Via, bei einem Mikrokanal 17 auch Microvia genannt. Die Viabeziehungsweise Microvia-Technologie ist eine Standard-Technologie zur Durchkontaktierung der Lagen 6, 8 bei Mehrlagenleiterplatinen 1 (Multilayerplatinen). Die Querverbindung 15 ist lateral zentral (in der Mitte oder in etwa in der Mitte) unterhalb der ersten Leiterstruktur 3 angeordnet. Diese weist eine zentral angeordnete Öffnung 19 auf. Weiterhin weist die erste Leiterstruktur 3 auf ihrer Außenseite 20 eine durch Galvanisieren hergestellte, als Goldschicht 21 ausgebildete elektrisch leitende Schicht 22 auf.

Die Galvanisierung der Außenseite 20 der ersten Leitestruktur 3 erfolgt mit den Schritten:
- Einbringen des Verbindungskanals 18, der von der ersten Leiterstruktur 3 zu der darunter liegenden, zweiten Leiterstruktur 9 der Mehrlagenleiterplatte 1 führt,
- Galvanisieren des Verbindungskanals 18 zum elektrischen Verbinden der beiden Leiterstrukturen 3, 9 durch Erzeugung der Querverbindung 15,
- Anlegen eines elektrischen Potentials an die zweite Leiterstruktur 9 zwecks Beaufschlagung der ersten Leiterstruktur 3 mit diesem Potential.
- Verwenden dieses Potentials für eine erfolgende Galvanisierung der ersten Leiterstruktur 3 zum Erzeugen der elektrisch leitenden Schicht 22 auf der Außenseite 20 der ersten Leiterstruktur 3.

Die Figur 2 zeigt die Mehrlagenleiterplatte 1 nach einem anschließenden Trennen der Querverbindung 15 durch Ausbohren des Verbindungskanals 18. Die Oberfläche 23 des so entstandenen, galvanisierungsschichtfreien Kanals 24 weist keine Leitfähigkeit auf. Somit ist die Querverbindung aufgetrennt und die erste Leiterstruktur 3 und die zweite Leiterstruktur 9 sind elektrisch von einander isoliert. Die erste Leiterstruktur 3 kann nun als Antenne 25 der Hochfrequenzschaltung 13 genutzt werden. Die innerhalb der ersten Leiterstruktur 3 entstandene Öffnung 19 und der nachträglich aufgebohrte galvanisierungsschichtfreie Verbindungskanals 24 haben dabei nur einen geringen Einfluss auf die Antenneneigenschaften.

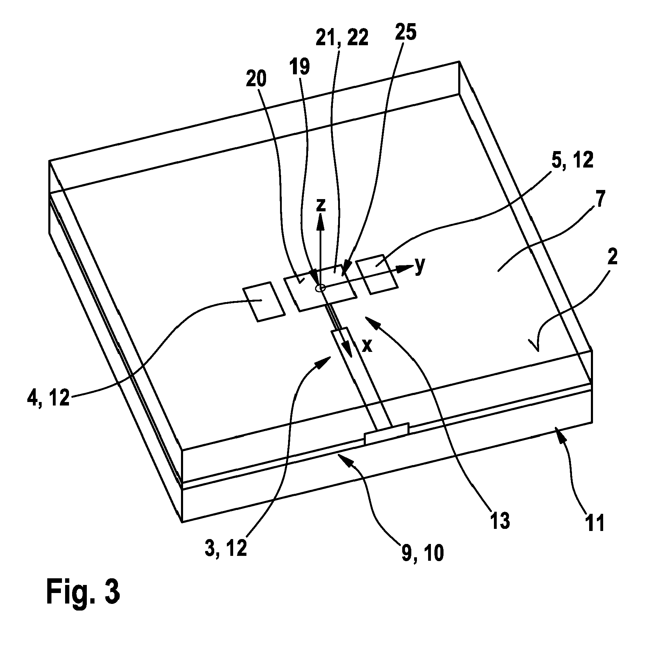

Die Figur 3 zeigt die Mehrlagenleiterplatte 1 in einer dreidimensionalen Ansicht, bei der die laterale Strukturierung der Hochfrequenzschaltung 13 mit der Antenne 25 erkennbar ist.

## Patentansprüche

1. Verfahren zum Galvanisieren mindestens einer ersten Leiterstruktur, die sich auf der Oberseite einer Mehrlagenleiterplatte befindet, mit folgenden Schritten:
- Einbringen eines Verbindungskanals, der von der ersten Leiterstruktur zu einer darunter liegenden, zweiten Leiterstruktur der Mehrlagenleiterplatte führt,
- Galvanisieren des Verbindungskanals zum elektrischen Verbinden der beiden Leiterstrukturen durch Erzeugung einer Querverbindung,
- Anlegen eines elektrischen Potentials an die zweite Leiterstruktur zwecks Beaufschlagung der ersten Leiterstruktur mit diesem Potential,
- Verwenden dieses Potentials für eine erfolgende Galvanisierung der ersten Leiterstruktur zum Erzeugen einer elektrisch leitenden Schicht auf der Außenseite der ersten Leiterstruktur und
- Trennen der Querverbindung durch Ausbohren des Verbindungskanals.

2. Verfahren nach Anspruch 1, **dadurch gekennzeichnet, dass** der Verbindungskanal ein Mikrokanal ist.

3. Verfahren nach einem der vorhergehenden Ansprüche, **dadurch gekennzeichnet, dass** das Einbringen des Verbindungskanals mittels Laserbohren oder Plasmaätzen erfolgt.

4. Verfahren nach einem der vorhergehenden Ansprüche, **dadurch gekennzeichnet, dass** die erste Leiterstruktur eine Hochfrequenz-Leiterstruktur ist.

5. Verfahren nach einem der vorhergehenden Ansprüche, **dadurch gekennzeichnet, dass** die erste Leiterstruktur eine Antenne ist.

6. Verfahren nach einem der vorhergehenden Ansprüche, **dadurch gekennzeichnet, dass** die elektrisch leitende Schicht eine Goldschicht ist.

7. Mehrlagenleiterplatte mit einer galvanisierten ersten Leiterstruktur auf der Oberseite der Mehrlagenleiterplatte, insbesondere mit einer mittels eines Verfahrens nach mindestens einem der vorhergehenden Ansprüche galvanisierten ersten Leiterstruktur, wobei diese eine elektrisch leitende Schicht auf ihrer Außenseite aufweist, **dadurch gekennzeichnet, dass** ein galvanisierungsschichtfreier Kanal (24) von der ersten Leiterstruktur (3) zu einer darunterliegenden, zweiten Leiterstruktur (9) der Mehrlagenleiterplatte (1) führt.

8. Mehrlagenleiterplatte nach Anspruch 7, **dadurch gekennzeichnet, dass** die erste Leiterstruktur (3) eine Hochfrequenz-Leiterstruktur (12) ist.

9. Mehrlagenleiterplatte nach einem der vorhergehenden Ansprüche, **dadurch gekennzeichnet, dass** die erste Leiterstruktur (3) eine Antenne (25) ist.

10. Mehrlagenleiterplatte nach einem der vorhergehenden Ansprüche, **dadurch gekennzeichnet, dass** die elektrisch leitende Schicht (22) eine Goldschicht (21) ist.
